**Europäisches Patentamt**

**European Patent Office**

**Office européen des brevets**

(19)

(11) Veröffentlichungsnummer: **0 258 629**

**A2**

(12) # EUROPÄISCHE PATENTANMELDUNG

(21) Anmeldenummer: **87110930.2**

(51) Int. Cl.⁴: **H01H 85/44 , H04Q 1/14**

(22) Anmeldetag: **28.07.87**

(30) Priorität: 25.08.86 DE 3628837
25.08.86 DE 3628809
25.08.86 DE 3628807
25.08.86 DE 3628805

(43) Veröffentlichungstag der Anmeldung:
**09.03.88 Patentblatt 88/10**

(84) Benannte Vertragsstaaten:
**AT BE CH DE FR GB LI NL SE**

(71) Anmelder: **Siemens Aktiengesellschaft Berlin und München**
**Wittelsbacherplatz 2**
**D-8000 München 2(DE)**

(72) Erfinder: **Scholtholt, Hans, Ing.-(grad.)**
**Tannenstrasse 4**
**D-8044 Lohhof(DE)**
Erfinder: **Steiner, Ewald, Ing.-(grad.)**
**Fichtenweg 11**
**D-8137 Berg 3(DE)**

(54) **Baugruppe zum Sichern von elektrischen Leitungen in Telekommunikationsanlagen.**

(57) Die an einen Schichtbaustein eines Verteilers der Anlage anschaltbare Baugruppe (1) ist mit Überspannungsableitern (6) als Querglied gegen Erde und Stromsicherungen (19) als Längsglied versehen. Diese sind an einem Trägerteil der Baugruppe gehalten, das aus einer Leiterplatte (2) und einem Gehäuseteil (3) gebildet ist. Kontaktteile (4, 18) für die Stromsicherungen (5, 19) sind in die durchkontaktierten Lötaugen der Leiterplatte (2) eingelötet.

EP 0 258 629 A2

## FIG 1

Xerox Copy Centre

## Baugruppe zum Sichern von elektrischen Leitungen in Telekommunikationsanlagen

Die Erfindung bezieht sich auf eine Baugruppe zum Sichern von elektrischen Leitungen in Verteilern von Telekommunikations-, insbesondere Fernsprechanlagen.

Eine derartige Baugruppe ist durch die DE-PS 32 12 013 bekannt geworden. Danach ist die Baugruppe an Steckkontakte eines Schichtbausteines des Verteilers anschaltbar. Sie ist mit aneinandergereihten Überspannungsableitern als Querglied gegen Erde und Stromsicherungen als Längsglied bestückt. Diese sind an einem Trägerteil der Baugruppe gehalten und über in zwei Ebenen des Trägerteiles angeordnete Kontaktstücke mit den Steckkontakten des Schichtbausteines verbunden. Die Kontaktstücke sind in das als Spritzgußteil ausgebildete Trägerteil eingelassen. Die röhrchenförmigen Stromsicherungen sind an ihren Enden zwischen hochgebogenen Kontaktteilen der Kontaktstücke gehalten. Es ist zweckmäßig, die Kontaktstücke durch Umspritzen in dem Trägerteil sicher zu befestigen. Dies ist jedoch bei eng aneinandergereihten Kontaktstücken, die in zwei Ebenen übereinander liegen mit Schwierigkeiten verbunden.

Der Erfindung liegt die Aufgabe zugrunde, eine mit Stromsicherungen und Überspannungsableitern bestückte Baugruppe so auszubilden, daß sie mit geringem Aufwand hergestellt werden kann.

Diese Aufgabe wird durch die Erfindung gemäß Anspruch 1 gelöst. Dadurch werden die Vorteile eines Spritzgußteiles mit denen einer gedruckten Leiterplatte verbunden. Die Baugruppe kann zwecks besserer Herstellung und Bestückung sowie Handhabung optimal gestaltet werden. Die kostengünstig herzustellende Leiterplatte kann ohne Schwierigkeiten beidseitig mit Leiterbahnen versehen werden. Die Kontaktteile können in durchkontaktierte Lötaugen der Leiterplatte eingesetzt und mit dieser z. B. durch Schwallöten verbunden werden. Das Gehäuseteil dient der optimalen Gestaltung der Baugruppenoberfläche. Es kann mit Vorsprüngen und Ausnehmungen zur Aufnahme und Lagesicherung der Stromsicherungen, der Überspannungsableiter und der Kontaktteile versehen werden. Außerdem kann es Versteifungsrippen aufweisen, die zur mechanischen Stabilisierung der Baugruppe beitragen.

Vorteilhafte Weiterbildungen der Erfindung sind in den Ansprüchen 2 bis 12 gekennzeichnet.

Die Anpassung der Baugruppe an unterschiedliche Sicherungsgrößen oder -typen ist bei einer Baugruppe mit umspritzten Kontaktstükken nicht möglich. Bei der Weiterbildung nach Anspruch 2 können in die Lötaugen der Leiterplatte beliebig geformte Kontaktteile unschwierig eingelötet werden.

Bei der Weiterbildung nach Anspruch 3 weist das Gehäuseteil angespritzte Haltezapfen für die Leiterplatte auf. Derartige Haltezapfen können in entsprechende Bohrungen der Leiterplatte eingesetzt werden. Durch Warmprägen der Zapfenenden wird eine sichere Verbindung hergestellt.

Die relativ langen Stromsicherungen nach Anspruch 4 werden an ihren Längsseiten kontaktiert. Für die überstehenden Enden sind in dem Trägerteil Ausnehmungen vorgesehen, die zugleich der seitlichen Führung der Stromsicherungen dienen können.

Die Weiterbildung nach Anspruch 5 ermöglicht den Einsatz von sehr kurzen Feinsicherungen. Anstelle der gabelförmigen Kontaktteile sind nun U-förmig zu den Stromsicherungen hin gebogene Kontaktteile vorgesehen. Dabei ist die Länge der Basisabschnitte der Kontaktteile durch die Länge der Stromsicherung bedingt. Durch Variation des Schenkelabstandes kann das Kontaktteil an unterschiedlich lange Stromsicherungen angepaßt werden.

Durch die stirnseitige Anlage der Kontaktteile können diese so schmal wie die Stromsicherungen gehalten werden. Da die Kontaktteile in der Längsrichtung der Stromsicherungen ausgelenkt werden, kann der Teilungsabstand zwischen den Stromsicherungen gering gehalten werden. Die Kontaktteile können im Bestückungsabstand ausgestanzt und in ein Bestückungswerkzeug eingesetzt werden. Dadurch verringert sich der Herstellungsaufwand. Durch die schräge Neigung der Kontaktteile im Berührungsbereich mit den Stromsicherungen werden diese gegen die Basis des Trägerteils gedrückt und in dieser Stellung sicher gehalten.

Durch die Weiterbildung nach Anspruch 6 wird erreicht, daß bei starker Biegebelastung des Kontaktteiles dessen Schrägstellung verstärkt wird. Die Berührungspunkte zu den Kontaktflächen der Stromsicherung liegen in der Nähe der Abstützstelle, so daß die Einspannkraft entsprechend hoch ist.

Durch die Weiterbildung nach Anspruch 7 können die Kontaktteile mit in der Basis des Trägerteils angeordneten Leiterbahnen elektrisch verbunden werden. Das Trägerteil kann z. B. aus einer Leiterplatte und einem Gehäuseteil bestehen, das als Spritzgußteil ausgebildet ist und das mit Aufnahmeformen für die Sicherungselemente versehen ist. An diesem Gehäuseteil können Stützschultern zum Abstützen der Kontaktteile an ihren der Basis abgewandtem Ende vorgesehen sein.

Die Weiterbildung nach Anspruch 8 setzt voraus, daß die beiden Seitenschenkel des U-förmig gebogenen Kontaktteils hinreichend weit voneinander entfernt sind. Dadurch ist es möglich, die Stromsicherungen beim Einsetzen schräg gegen eines der Kontaktteile zu drücken und dessen freie Federschenkel soweit auszulenken, daß das andere Ende der Stromsicherung an dem gegenüberliegenden Kontaktteil entlang in seine Einsetzstellung gebracht werden kann.

Die Weiterbildung nach Anspruch 9 ermöglicht eine seitliche Fixierung der Stromsicherungen.

Die Weiterbildung nach Anspruch 10 ergibt eine Zweipunktanlage eines Kontaktteils an der Stromsicherung.

Durch die Weiterbildung nach Anspruch 11 ist es möglich, das Kontaktteil unmittelbar mit dem Erdungsfinger eines Erdungsvielfachs zu kontaktieren. Dadurch wird z. B. beim Abschmelzen eines Schmelzringes der Baugruppe der Erdungsfinger unmittelbar auf die überstehenden Lappen aufgesetzt und die nach außen führende Teilnehmerleitung an Erde gelegt.

Durch die Weiterbildung nach Anspruch 12 liegt das freie Ende des Kontaktteils unter Vorspannung an dem Basisteil an, so daß beim Einsetzen der Stromsicherung nur eine geringe Auslenkung nötig ist, ohne daß dadurch die Kontaktkraft verringert würde.

Im folgenden wird die Erfindung anhand von in der Zeichnung dargestellten Ausführungsbeispielen näher erläutert. Es zeigen:

FIG 1 einen seitlichen Schnitt durch eine Baugruppe zum Sichern von elektrischen Leitungen in Verteilern von Fernsprechvermittlungsanlagen,

FIG 2 eine Draufsicht auf die Baugruppe nach FIG 1,

FIG 3 eine Seitenansicht eines Teiles der Baugruppe nach FIG 1,

FIG 4 die Baugruppe nach FIG 1 mit anderen Kontaktteilen und anderen Stromsicherungen,

FIG 5 eine Draufsicht auf die Baugruppe nach FIG 4,

FIG 6 eine Seitenansicht eines Kontaktteils der Baugruppe nach FIG 4,

FIG 7 eine Draufsicht auf das Kontaktteil nach FIG 6,

FIG 8 einen Teil der Baugruppe nach FIG 4 mit einer Stromsicherung unmittelbar vor dem Einsetzen.

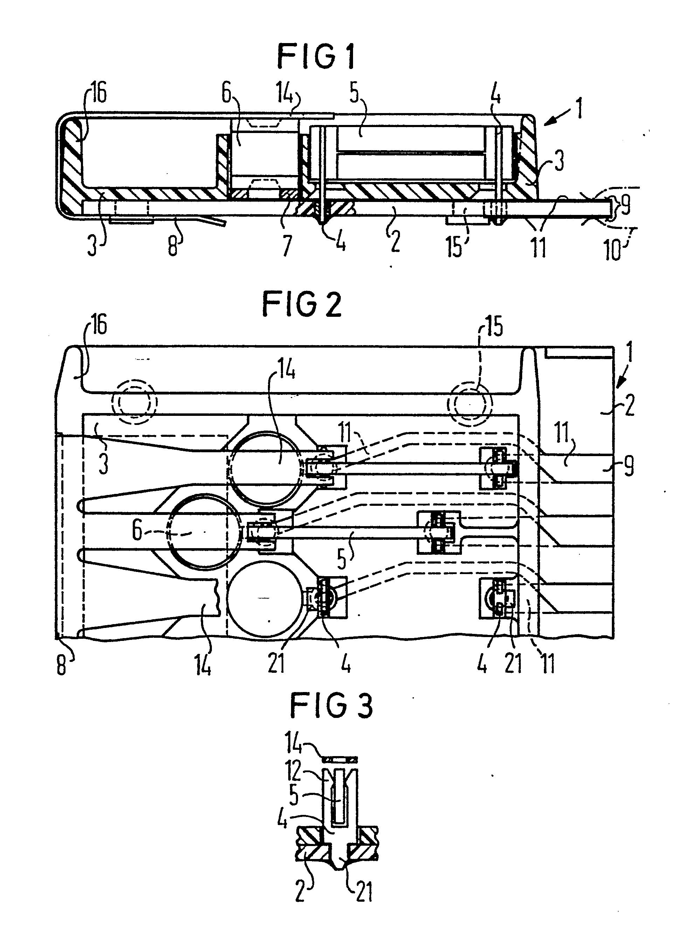

Nach den Figuren 1, 2 und 3 besteht eine Baugruppe 1 aus einer doppelseitig kaschierten Leiterplatte 2, einem Gehäuseteil 3, Kontaktteilen 4, Stromsicherungen 5, Überspannungsableitern 6, Schmelzstücken 7 und einem Erdungsvielfach 8. Die Leiterplatte 2 ist entlang einer ihrer Längskanten zu beiden Seiten mit Kontaktflächen 9 für Kontaktfedern 10 eines Schichtbausteines in einem Verteiler einer Fernsprechvermittlungsanlage versehen. Die beiden übereinander liegenden Kontaktfedern 10 sind über Leiterbahnen 11 der Leiterplatte 2, die Kontaktteile 4 und die Stromsicherungen 5 miteinander elektrisch verbunden. Eine der Leiterbahnen 11 ist auf der den Stromsicherungen 5 und Überspannungsableitern 6 zugewandten Seite der Leiterplatte 2 angeordnet und über die entsprechende Kontaktfeder 10 mit einer Ader einer nach außen führenden Teilnehmerleitung verbunden. Diese Leiterbahn erstreckt sich bis unter den Überspannungsableiter 6 wo sie eine erweiterte Kontaktzone für das Schmelzstück 7 bildet, das zwischen dem Überspannungsableiter 6 und der Kontaktzone gehalten ist. Diese Leiterbahn 11 ist dabei über ein durchkontaktiertes Lötauge geführt, das der Kontaktzone für den Überspannungsablei ter 6 unmittelbar benachbart ist. In dieses Lötauge ist eines der Kontaktteile 4 für die Stromsicherung eingelötet. Das andere Kontaktteil 4 ist in ein den Kontaktflächen 9 benachbartes Lötauge eingelötet, das mit der auf der anderen Seite der Leiterplatte 2 liegenden Leiterbahn verbunden ist.

Die flachen Kontaktteile 4 sind gabelartig ausgebildet und halten zwischen Federschenkeln 12 die Stromsicherungen 5 an deren Polen. Sie sind senkrecht stehend mit einem Lötdorn 13 in die durchkontaktierten Bohrungen der Leiterplatte 2 eingelötet. Die über der Leiterplatte 2 senkrecht stehenden, zueinander versetzten Überspannungsableiter 6 sind zwischen Federfingern 14 des gefiederten Erdungsvielfaches 8 und den Schmelzstücken 7 gehalten. Die Federfinger 14 erstrecken sich bis über die freie Stirnseite der benachbarten, zueinander versetzten Kontaktteile 4. Der Abstand zwischen den Federfingern 14 und den Kontaktteilen 4 ist kleiner als die Dicke des Schmelzstückes 7. Beim Abschmelzen desselben legt sich der Federfinger 14 an das Kontaktteil 4 an, so daß der Leitungszug unmittelbar an Erde gelegt wird. Die Federfinger 14 sind an ihren freien Enden über den Kontaktteilen 4 geschlitzt, so daß sich zu diesen ein Doppelkontakt ergibt.

Das Erdungsvielfach 8 ist als U-förmig gebogenes Blechteil ausgebildet, das sich mit einem Schenkel an die Leiterplatte 2 anlegt und die Baugruppe 1 umgreift.

Das aus Spritzguß hergestellte Gehäuseteil 3 ist auf die Leiterplatte 2 aufgesetzt und mit diesem durch Warmprägen von hervorstehenden Zapfen 15 verbunden, die durch Bohrungen der Leiterplatte 2 hindurchragen. Das Gehäuseteil 3 bildet Aufnahmen für die Überspannungsableiter 6 und die Stromsicherungen 5, es ist mit einem umlaufenden Schutzrand 16 versehen, der die Baugruppe mechanisch stabilisiert. Außerdem sind an dem Gehäuseteil 3 nicht dargestellte Griffteile zur besseren Handhabung der Baugruppe angebracht.

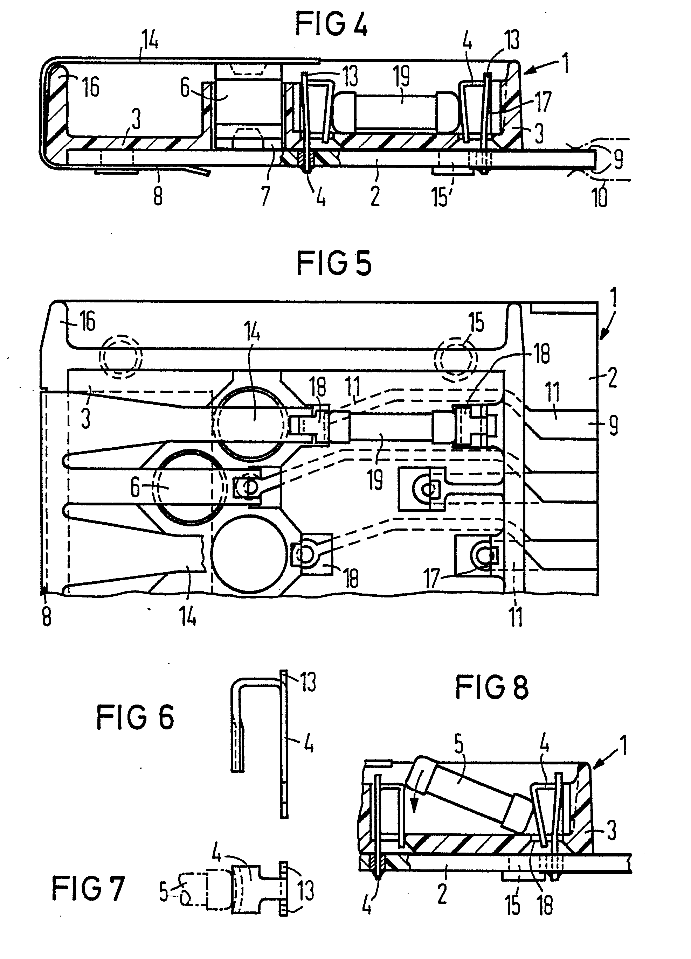

Nach den Figuren 4 und 5 ist die Baugruppe 1 anstelle der flachen Kontaktteile 4 (Figur 1) mit U-förmig gebogenen Kontaktteilen 18 versehen, die mit einem Schenkel in ein Lötauge der Leiterplatte 2 eingelötet sind. Die auslenkbaren freien Federschenkel sind einander paarweise zugewandt und klemmen jeweils eine röhrchenförmige kürzere Stromsicherung 19 stirnseitig ein. Die freien Schenkel der Kontaktteile 18 verlaufen zur Trägerplatte hin auseinandergespreizt und drücken dadurch die Stromsicherung 19 gegen die Basis des Gehäuseteils 3. Der Abstand der beiden Schenkel des Kontaktteils 18 ist der Länge der Stromsicherung 19 angepaßt. Das Kontaktteil 18 liegt mit seinem der Leiterplatte abgewandten Ende auf der Stromsicherung gegenüberliegenden Seite an einer Anschlagschulter 17 des Gehäuseteils 3 an. Dadurch wird der Federweg verringert und die Klemmkraft erhöht. Die entsprechend der Lage der Überspannungsableiter 4 zueinander versetzten Kontaktteile 18 weisen in der Verlängerung des eingelöteten Schenkels von der Leiterplatte 2 wegweisende überstehende Lappen 13 auf, die gegenüber den Federfingern 14 die gleiche Funktion haben wie die flachen Kontaktteile nach FIG 1.

Nach den Figuren 6 und 7 ist der freie Federschenkel des Kontaktteils 18 in seiner Längsrichtung zur Stromsicherung 19 hin konkav gewölbt, wodurch diese in ihrer Seitenlage gesichert wird.

Nach Figur 8 wird die Stromsicherung 19 zunächst mit einem Ende schräg stehend gegen das Kontaktteil 18 gedrückt. Dieses hat eine so große Federreserve, daß es genügend weit ausgelenkt wird, um die andere Stirnseite der Stromsicherung 19 an den Basisabschnitt des anderen Kontaktteils 18 vorbeigleiten zu lassen. Dieses liegt mit seinem freien Schenkelende an einer Öffnung 20 an, die ein zu starkes Zurückfedern des vorgespannten freien Federschenkels verhindert.

**Ansprüche**

1. Baugruppe zum Sichern von elektrischen Leitungen in Verteilern von Telekommunikations-, insbesondere Fernsprechanlagen, wobei die an Kontaktfedern (10) eines Schichtbausteines des Verteilers anschaltbare Baugruppe (1) mit aneinandergereihten Überspannungsableitern (6) als Querglied gegen Erde und Stromsicherungen (5) als Längsglied bestückt sind, die an einem Trägerteil (2, 3) der Baugruppe (1) gehalten und mit Kontaktteilen (4) kontaktiert sind, die über in zwei Ebenen des Trägerteiles (2, 3) angeordnete elektrische Leiter mit den Kontaktfedern (10) verbindbar sind, **dadurch gekennzeichnet, daß** das Trägerteil aus einem Gehäuseteil (3) und einer doppelseitig kaschierten Leiterplatte (2) besteht, auf die das Gehäuseteil (3) aufgesetzt ist, das mit Aufnahmeformen für die Überspannungsableiter (6) und/oder die Stromsicherungen (5) versehen ist und daß die Kontaktteile (4) in Lötaugen der Leiterplatte (2) eingelötet sind.

2. Baugruppe nach Anspruch 1, **dadurch gekennzeichnet,** daß in die Lötaugen der Leiterplatte (2) unterschiedliche Kontaktteile zur Aufnahme verschiedener Typen von Stromsicherungen und/oder Überspannungsableitern einsetzbar sind.

3. Baugruppe nach Anspruch 1 oder 2, **dadurch gekennzeichnet,** daß das Gehäuseteil (3) angespritzte Zapfen (15) zum Halten der Leiterplatte aufweist.

4. Baugruppe nach Anspruch 1, 2 oder 3, **dadurch gekennzeichnet,** daß die länglichen Stromsicherungen (5) als flache Plättchen mit geätzten Leiterbahnen und an beiden Enden mit seitlichen Kontaktflächen ausgebildet sind, daß die flachen Kontaktteile (4) die Stromsicherungen (5) an ihren Kontaktflächen gabelförmig umgreifen und daß das Gehäuseteil (3) Ausnehmungen (21) aufweist, in die die Enden der Stromsiche rungen (5) hineinragen.

5. Baugruppe nach Anspruch 1, 2 oder 3, **dadurch gekennzeichnet,** daß die zylindrischen Stromsicherungen (19) an ihren Stirnflächen zwischen den gegeneinander federnden Kontaktteilen (18) eingeklemmt sind und längsseitig an einer Basis des Gehäuseteils (3) der Baugruppe anliegen, daß die Stirnflächen der Stromsicherungen (19) zumindest in der Richtung senkrecht zur Bestückungsebene der Baugruppe (1) Abschrägungen oder Abrundungen aufweisen und daß die Kontaktteile (18) im Bereich ihrer Berührungsstellen zu den eingesetzten Stromsicherungen (19) zur Leiterplatte (2) hin auseinandergespreizt verlaufen.

6. Baugruppe nach Anspruch 5, **dadurch gekennzeichnet,** daß die Kontaktteile (18) als Biegefedern in Form von Blattfedern ausgebildet sind, die sich im wesentlichen senkrecht zur Bestückungsebene erstrecken, deren freies Ende der Leiterplatte (2) zugewandt ist und die sich auf der Leiterplatte 2 abgewandten Seite der eingesetzten Stromsicherungen (19) an dem Gehäuseteil (3) abstützen.

7. Baugruppe nach Anspruch 4 oder 5, **dadurch gekennzeichnet,** daß die Kontaktteile (4) in sich U-förmig zur Leiterplatte (2) hin zurückgebogen und an dieser befestigt sind.

8. Baugruppe nach Anspruch 6 oder 7, **dadurch gekennzeichnet,** daß die beiden Schenkel der Kontaktteile (18) bei eingesetzten Stromsicherungen (5) eine Federreserve aufweisen.

9. Baugruppe nach einem der vorhergehenden Ansprüche, **dadurch gekennzeichnet,** daß die Kontaktteile (18) im Berührungsbereich der Stromsicherungen (19) zu diesen hin im Querschnitt konkav gewölbt sind.

10. Baugruppe nach Anspruch 5, **dadurch gekennzeichnet,** daß die Kontaktteile (19) stärker gewölbt sind als die Stirnflächen der Stromsicherungen (19).

11. Stromsicherung nach einem der vorhergehenden Ansprüche, **dadurch gekennzeichnet,** daß die zumindest den Überspannungsableitern (6) benachbarte Kontaktteile (18) im Bereich ihres Basisabschnitts von der Leiterplatte (2) wegweisende überstehende Lappen (13) zum Aufsetzen von Erdungsfingern (14) eines gefiederten Erdungsvielfaches (8) der Baugruppe (1) aufweisen.

12. Anspruch nach einem der vorhergehenden Ansprüche, **dadurch gekennzeichnet,** daß die freien Enden der Kontaktteile in Öffnungen (20) des Gehäuseteiles (3) hineinragen und bei nichteingesetzter Stromsicherung unter Vorspannung an einer Innenwand der Öffnung (20) anliegen.

FIG 1

FIG 2

FIG 3

## FIG 4

## FIG 5

## FIG 6

## FIG 7

## FIG 8